# EUROPÄISCHE PATENTANMELDUNG

(11) **EP 1 111 585 A2**
(43) Veröffentlichungstag der Anmeldung: **27.06.2001**
(21) Anmeldenummer: 00125253.5
(22) Anmeldetag: 24.11.2000
(51) Int. Cl.: G10K 15/00

(54) **Verfahren zur Erregung von Lambwellen in einer Platte, insbesondere in einer Behälterwand, und Vorrichtung zur Durchführung des Verfahrens und zum Empfang der erregten Lambwellen**

(30) Priorität: 22.12.1999 DE 19961857
(71) Anmelder: Endress + Hauser GmbH + Co., 79689 Maulburg (DE)
(72) Erfinder: Getman, Igor, 79539 Lörrach (DE); Hardell, Alexander, 79539 Lörrach (DE); Lopatin, Sergej, 79539 Lörrach (DE)
(74) Vertreter: Andres, Angelika

(57) **Zusammenfassung**

Zur Erregung von Lambwellen in einer Platte (8) oder Behälterwand (8) wird vorgeschlagen, einen an sich bekannten IDT-Wandler (interdigital transducer), der aus einer Schicht (1) aus piezo-elektrischem Material besteht, auf deren einen Oberfläche zwei fingerartig ineinander greifende Elektroden (2, 3) aufgebracht sind, mit der den Elektroden (2, 3) abgewandten Oberfläche akustisch mit der Platte (8) oder Behälterwand (8) zu koppeln. Wird an die Anschlüsse (6, 7) der Elektroden (2, 3) eine hochfrequente Wechselspannung angelegt, so wird in der piezo-elektrischen Schicht (1) eine Dickenvibration ausgelöst. Wenn die Ausbreitungs- oder Schallgeschwindigkeit der in dieser Dickenvibration resultierenden Longitudinalwellen in der piezo-elektrischen Schicht (1) abgestimmt wird auf die Phasengeschwindigkeit, mit der sich eine Lambwelle des *s*₀-modes im Material der Platte (8) oder Behälterwand (8) ausbreitet, so werden infolge der akustischen Kopplung zwischen der piezoelektrischer Schicht (1) und der Platte (8) oder Behälterwand (8) darin durch Resonanzwirkung nur Lambwellen des *s*₀-modes ausgelöst. Die Abstimmung kann erfolgen, indem der Abstand (D) zwischen den Fingern (4, 5) der Elektroden (2, 3) so gewählt wird, daß er gleich der halben Wellenlänge λ/2 der auszulösenden Dickenvibration der piezo-elektrischen Schicht (1) ist

## Beschreibung

Die Erfindung bezieht sich auf ein Verfahren zur Erregung von Lambwellen in einer Platte, insbesondere in einer Behälterwand, und eine Vorrichtung zur Durchführung des Verfahrens und zum Empfang der erregten Lambwellen.

Die Nutzung von Lambwellen bei Füllstandsmeßgeräten ist an sich bekannt. Die in einer Behälterwand von einem Lambwellenerreger in Form eines elektroakustischen Wandlers hervorgerufenen Lamb-wellen breiten sich als periodisch sinusförmige Verformung beider Oberflächen aus und können von einem im Abstand an derselben Behälterwand vorgesehenen Lambwellenempfänger aufgenommen und in ein elektrisches Signal zurückverwandelt werden, solange sich die Lambwellen ungehindert ausbreiten können. Wird die Ausbreitung der Lambwellen dagegen gedämpft, was der Fall ist, wenn der Behälterinhalt ein bestimmtes Niveau im Bereich der Füllstandsmeßeinrichtung erreicht, so bleibt das Signal aus oder wird zumindest so stark gedämpft, daß dies als Anzeige für den erreichten Füllstand dienen kann.

Basierend auf der Tatsache, daß sich Lambwellen aus senkrecht zur Oberfläche schwingenden Scherungs- oder Tranversalwellen und tangential schwingenden Kompressions- oder Longitudinalwellen zusammensetzen, können Lambwellen in einer Platte oder Behälterwand von gewisser Elastizität durch schräg auf diese auftreffende Ultraschallwellen ausgelöst werden.

Nach einer bekannten Methode können diese schräg auf die Platte oder Behälterwand auftreffenden Ultraschallwellen mit Hilfe eines Prismas oder eines prismenförmigen Formteils erzeugt werden, das auf der Platte befestigt ist und auf dessen Schräge ein piezo-elektrisches Element fest angeordnet ist, das über Elektroden mit einer Wechselspannungsquelle verbunden ist. Die durch einen Wechselspannungsimpuls in dem piezo-elektrischen Element ausgelöste Longitudinalwelle (Ultraschallwelle) wird durch das Prisma auf die Platte übertragen und trifft auf diese in einem vom Öffnungswinkel θ des Prismas abhängigen Winkel auf. Vom Öffnungswinkel θ des Prismas abhängig ist dann auch das anteilige Verhältnis der Longitudinal- und Transversalwellen an den resultierenden Lambwellen und damit deren Amplituden. Abhängig von der Dicke d der Platte oder der Behälterwand und der Erregerfrequenz ω können Wellen verschiedener Ordnungszahl erregt werden, von denen aber nur die der Ordnungszahl Null (zeroth mode) an die Oberfläche gelangen und in einer sich periodisch, sinusförmig ausbreitenden Verformung der Oberflächen resultieren, die bezüglich der Mittelebene symmetrisch oder antisymmetrisch sein kann. Für die praktische Anwendung sind insbesondere die symmetrischen Lambwellen der Ordnungszahl Null, die als s₀ -mode (zeroth symmetrical mode) bezeichnet werden, von Bedeutung. (ULTRASONIC TECHNOLOGY, A Series of Monographs, General Editor Lewis Balamuth, Cavitron Corporation, New York,N.Y, RAYLEIGH AND LAMB WAVES, Physical Theory and Applications, I.A.Viktorov, Seite 69,70 und Seite 82 Abs.3).

Um die Phasengeschwindigkeit der betreffenden Lambwelle und die Wellenlänge auf der Oberfläche zu bestimmen bzw. einzustellen, werden also spezielle Prismen benutzt. Weiter ist bei dieser Methode der Lambwellenerregung die Größe bzw. die Abmessung der sogenannten Erregungszone an der Grenzfläche zwischen Prisma und Platte oder Behälterwand von Bedeutung, die bestimmt wird von der Projektion der auf der Schrägen des Prismas von dem piezo-elektrischen Element bedeckten Fläche auf die Grenzfläche zwischen Prisma und Platte bzw. Behälterwand. Die Höhe der Maxima der erregten Lambwellen ist dieser Erregungszone direkt proportional (Seite 84, Abs. 2, Seite 87 bis 88 a.a.O.).

Eine Vorrichtung zur Füllstandsüberwachung in einem Behälter, die von dieser Methode Gebrauch macht, ist in der DE 689 03 015 T2 beschrieben.

Eine andere Methode nutzt die periodischen Strukturen auf der Wirkfläche eines Lambwellenerregers infolge einer Kolbenvibration. Dabei werden an bestimmten Stellen der Platte bzw. der Behälterwand Kompressionen erzeugt, deren periodischer Abstand durch die Phasengeschwindigkeit der entsprechenden Lambwelle bestimmt ist.

Ein Problem bei der Erregung von Lambwellen in einer Platte oder Behälterwand mittels Prismen ist die Impedanzanpassung an den Übergangsflächen zwischen Prisma und Behälterwand, wobei zu berücksichtigen ist, daß die Behälter, deren Füllstand überwacht werden soll, aus ganz unterschiedlichen Materialien, wie Stahl, Messing, Aluminium aber auch Glas u.a., bestehen können. Bei auftretenden Impedanzsprüngen zwischen den Prismen des Lambwellenerregers bzw. Lambwellenempfängers und der Behälterwand können Störeffekte in Form von parasitären Wellen oder Oberwellen auftreten. Die Eigenschaften der Prismen, die herkömmlich aus Kunststoff, vorzugsweise einem Polymer, gefertigt werden, können in weiten Grenzen variieren, abhängig von der Dichte, der Konzentration der Glasphase, des Flusses beim Pressen usw., so daß die Prismen an jeden Anwendungsfall speziell anzupassen sind. Des weiteren besteht eine nicht vernachlässigbare Temperaturabhängigkeit bestimmter Eigenschaften der Kunststoff-Prismen. Bei der Herstellung der Kunststoff-Prismen im Material auftretende Luftlöcher können die Eigenschaften des Prismas in unerwünschter Weise beeinflussen. Aus dem allen folgt, daß die Herstellung der Kunststoff-Prismen sehr aufwendig und kostenintensiv ist.

Aufgabe der Erfindung ist es, ein Verfahren zur Erregung von Lambwellen in einer Platte bzw. Behälterwand und eine Vorrichtung zur Durchführung dieses Verfahrens zu schaffen, bei dem auf ein Prisma verzichtet werden kann und bei dem eine einfache Einstellung und Anpassung der Phasengeschwindigkeit der erzeugten Lambwellen und der Wellenlänge z.B. entsprechend unterschiedlicher Materialien der Platte oder Behälterwand, in der sich die Lambwellen ausbreiten sollen, möglich ist.

Erfindungsgemäß wird dies erreicht, indem ein an sich bekannter IDT-Wandler (interdigital transducer) bestehend aus einer Schicht aus piezo-elektrischem Material, auf deren einen Oberfläche zwei fingerartig ineinander greifende Elektroden aufgebracht sind, mit der den Elektroden abgewandten Oberfläche akustisch mit der Platte oder Behälterwand gekoppelt wird und an die Anschlüsse der Elektroden eine hochfrequente Wechselspannung angelegt wird, die in der piezo-elektrischen Schicht zwischen den Elektrodenfingern periodisch auftretende Materialverdichtungen und Materialverdünnungen, eine sogenannte Dickenvibration, auslöst, wobei die Ausbreitungs- oder Schallgeschwindigkeit der daraus resultierenden Longitudinalwellen in der piezo-elektrischen Schicht abgestimmt wird auf die Phasengeschwindigkeit, mit der sich eine Lambwelle des *s*_{O}-modes im Material der Platte oder Behälterwand ausbreitet, indem der Abstand D zwischen den Fingern der Elektroden so gewählt wird, daß er gleich der halben Wellenlänge λ/2 der auszulösenden Longitudinalwelle in der piezo-elektrischen Schicht ist.

Nach dem neuen Verfahren wird für die Erregung von Lambwellen in einer Platte oder Behälterwand kein Prisma benötigt, so daß auch alle damit verbundenen Nachteile vermieden werden, wie z.B. die materialbedingte Temperaturabhängigkeit oder negative Einflüsse durch bei der Herstellung der Prismen im Kunststoff entstehende Luftlöcher.

Wegen der relativ guten Übereinstimmung der Ausbreitungs- oder Schallgeschwindigkeit der Longitudinalwellen in der piezo-elektrischen Schicht und der Phasengeschwindigkeit der s₀ -mode-Lambwelle in der Platte oder der Behälterwand wird infolge der akustischen Kopplung zwischen piezoelektrischer Schicht und Platte oder Behälterwand in dieser nach Aktivierung des IDT-Wandlers durch Resonanzwirkung nur eine *s*₀-mode-Lambwelle erzeugt. Parasitäre Störwellen oder Oberwellen werden so ausgeschlossen.

Die Arbeitsfrequenz des IDT-Wandlers als Lambwellenerreger muß abgestimmt werden auf den Abstand D zwischen den Elektrodenfingern und kann so auch verändert, d.h. an unterschiedliche Materialien der Platte oder Behälterwand angepaßt werden, ohne daß Veränderungen an den Abmessungen der piezo-elektrischen Schicht selbst vorgenommen werden müssen. Die Anpassung durch Veränderung des Abstandes der Elektrodenfinger eines IDT-Wandlers ist wesentlich einfacher und kostengünstiger ist als bei den bekannten Prismen-Lambwellenerregern durch Veränderung des Öffnungswinkels des Prismas. Dabei ist die gemessene Wirksamkeit des IDT-Wandlers als Lambwellenerreger vergleichbar mit der herkömmlicher Lambwellenerreger, bei denen eine piezo-elektrische Schicht auf einem Polymer-Prisma mit bestimmtem Öffnungswinkel für die Erregung der Lambwellen benutzt wird.

Die Abstimmung der Ausbreitungs- oder Schallgeschwindigkeit der Dickenvibration in der piezo-elektrischen Schicht bzw. der daraus resultierenden Longitudinalwellen an die Phasengeschwindigkeit der *s*₀-mode-Lambwelle im Material der Platte oder Behälterwand durch Veränderung des Abstandes D zwischen den Fingern der Elektroden des IDT-Wandlers kann durch FEM-Simulation (finite element method) vorgenommen werden.

Eine Vorrichtung zur Durchführung des erfindungsgemäßen Verfahrens besteht aus einem an sich bekannten IDT-Wandler (interdi-gital tranducer), der seinerseits aus einer piezo-elektrischen Schicht besteht, auf deren einen Oberfläche zwei fingerartig ineinander greifende Elektroden aufgebracht sind; er ist mit seiner den Elektroden abgewandten Oberfläche akustisch mit der Platte oder Behälterwand gekoppelt, und die Anschlüsse der Elektroden sind mit einer hochfrequenten Wechselspannungsquelle verbunden. Der Abstand zwischen den Fingern der beiden Elektroden ist dabei gleich der halben Wellenlänge λ/2 der bei Anliegen der hochfrequenten Wechselspannung durch den piezo-elektrischen Effekt hervorgerufenen Dickenvibration oder Longitudinalwelle in der piezo-elektrischen Schicht; so ist die Ausbreitungs- oder Schallgeschwindigkeit der Dickenvibration in der piezo-elektrischen Schicht, bzw. der daraus resultierenden Longitudinalwellen auf die Phasengeschwindigkeit einer Lambwelle des s₀ -modes im Material der Platte oder Behälterwand abgestimmt. Ein im Abstand zu dem als Lambwellenerreger wirkenden IDT-Wandler mit der Behälterwand ebenfalls akustisch gekoppelter, baugleicher IDT-Wandler empfängt die ausgelösten Lambwellen und wandelt sie in ein elektrisches Signal zurück.

Nach einer ersten Ausführungsform der Erfindung weisen die beiden Elektroden des IDT-Wandlers mindesten zwei Elektrodenfinger auf, die unter Einhaltung des gegenseitigen Abstandes D fingerartig ineinandergreifen.

Nach einer anderen Ausführungsform der Erfindung weisen die beiden Elektroden des IDT-Wandlers mehr als zwei Elektrodenfinger auf, die unter Einhaltung des gegenseitigen Abstandes D fingerartig ineinandergreifen.

Die piezo-elektrische Schicht des IDT-Wandlers besteht vorzugsweise einem piezo-elektrischen Keramikstoff oder einem piezoelektrischen Compositestoff.

Aufbau, Herstellung und Anpassung des erfindungsgemäßen Lambwellenerregers sind gegenüber den bekannten Prismen-Lambwellenerregern wesentlich einfacher und kostengünstiger.

Der erfindungsgemäße Lambwellenerreger ist zusammen mit einem in gleicher Weise aufgebauten Lambwellenempfänger als Sensor bei Füllstandsmeßeinrichtungen einsetzbar.

Im folgenden wird die Erfindung anhand der anhängenden Zeichnungen beispielhaft genauer beschrieben; es zeigen
Fig. 1 eine erste Ausführungsform eines Lambwellenerregers nach der Erfindung in perspektivischer Darstellung,
Fig. 2 eine zweite Ausführungsform eines Lambwellenerregers nach der Erfindung ebenfalls in perspektivischer Darstellung,
Fig. 3 schematisch die Erregung der Lambwellen durch einen erfindungsgemäßen Lambwellenerreger und ihre Ausbreitung in einer Platte bzw. Behälterwand,
Fig. 4 die beispielhafte Anwendung eines Lambwellenerregers gemäß Fig. 1 zusammen mit einem in gleicher Weise auf gebauten Lambwellenempfänger als Sensor für die Füllstandsmessung an einer Behälterwand und
Fig. 5 in einem Diagramm den prinzipiellen Verlauf der Gruppengeschwindigkeit c von Lambwellen des s₀-modes in Abhängigkeit von der Arbeitsfrequenz f mal der Wandstärke d einer Platte oder Behälterwand.

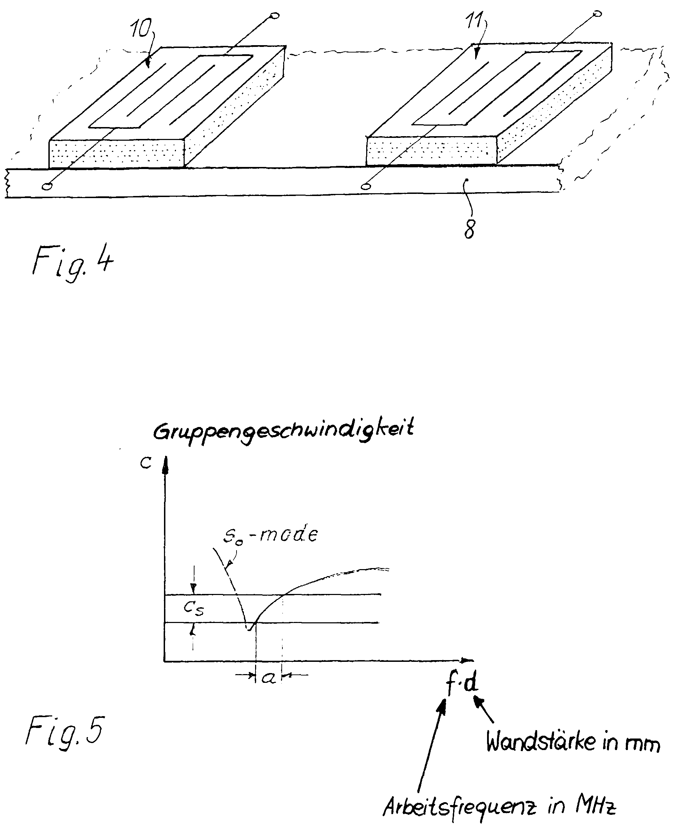

Nach der Erfindung wird die IDT-Struktur, d.h. die Struktur eines Interdigitalwandlers (interdigital transducer) zur Erregung der Lambwellen in einer Platte bzw. Behälterwand genutzt. Wie bereits erwähnt, ist für die praktische Nutzung vor allem der *s*₀-mode der Lambwellen von Bedeutung. *s*₀-mode-Lambwelle zeigt nämlich auch die beste Empfindlichkeit gegenüber einem Medium, z.B. einer Flüssigkeit, das mit der einen Seite der Platte bzw. der Innenfläche eines Behälters in Berührung kommt und entsprechend dem erreichten Füllstandsniveau dämpfend auf die Ausbreitung der Lambwellen wirkt. Lambwellen der Ordnungszahl Null (*s*_{O}-mode) greifen durch die ganze Platte oder Behälterwand durch und haben eine sich periodisch, sinusförmig ausbreitende Verformung beider Oberflächen der Platte oder Behälterwand zur Folge. Bei der Anwesenheit z.B. von Wasser erfährt eine sich in der Platte oder Behälterwand ausbreitende s_{O}-mode-Lambwelle eine Dämpfung, die über einen gleichbleibenden Frequenzbereich von 2,5 - 5 MHz*mm und auf die Entfernung von 1 cm (zwischen Lambwellenerreger und Lambwellenempfänger) bei ungefähr 6 dB mal 1 mm Platten- oder Wandstärke liegt. Im Vergleich zu anderen Moden der Lambwelle ist damit die Dämpfung *s*_{O}-mode -Lambwelle besonders ausgeprägt. Im Diagramm der Fig. 5 wird die Empfindlichkeit an dem rüsselartigen Verlauf der Gruppengeschwindigkeit c der *s*_{O}-mode-Lambwelle in Abhängigkeit von der Arbeitsfrequenz f mal der Wandstärke d des Behälters oder der Platte in dem angestrebten Arbeitsbereich a und der Schallgeschwindigkeit c_{S} deutlich; die Änderung ist in diesem Bereich am stärksten ausgeprägt. Des weiteren ist der Fig. 5 zu entnehmen, daß die Arbeitsfrequenz f der erregten s₀-mode-Lambwellen und die Wandstärke d des Behälters oder der Platte voneinander abhängen bzw. sich gegenseitig bestimmen, d.h. eine größere Wandstärke d erfordert eine niedrigere Arbeitsfrequenz f der *s*_{O}-mode-Lambwelle..

Die Erfindung basiert auf der relativ guten Übereinstimmung der Phasengeschwindigkeit der *s*_{O}-mode-Lambwelle in einer Materialplatte bzw. Behälterwand und der Ausbreitungs- oder Schallgeschwindigkeit einer aus einer Dickenvibration resultierenden Longitudinalwelle in einer Schicht aus piezo-elektrischem Material, vorzugsweise einem piezo-elektrischen Keramikstoff.

Die Phasengeschwindigkeit der *s*_{O}-mode-Lambwelle z.B. in einer Stahlplatte beträgt 3000 - 4000 m/s;
die Ausbreitungs- oder Schallgeschwindigkeit einer Longitudinalwelle in einer Schicht aus piezo-elektrischem Keramikstoff beträgt 3600 - 4000 m/s.

Eine in einer piezo-elektrischen Schicht ausgelöste Longitudinalwelle oder Dickenvibration dieser Ausbreitungs- oder Schallgeschwindigkeit wird also, sofern zwischen dieser piezo-elektrischen Schicht und einer Stahlplatte bzw. einer Behälterwand aus Stahl eine gute akustische Kopplung besteht, in dieser Platte oder Behälterwand durch Resonanzwirkung nur eine Lambwelle des S_{O}-modes hervorrufen; somit werden Störeffekte durch parasitäre Wellen oder Oberwellen von vornherein ausgeschlossen.

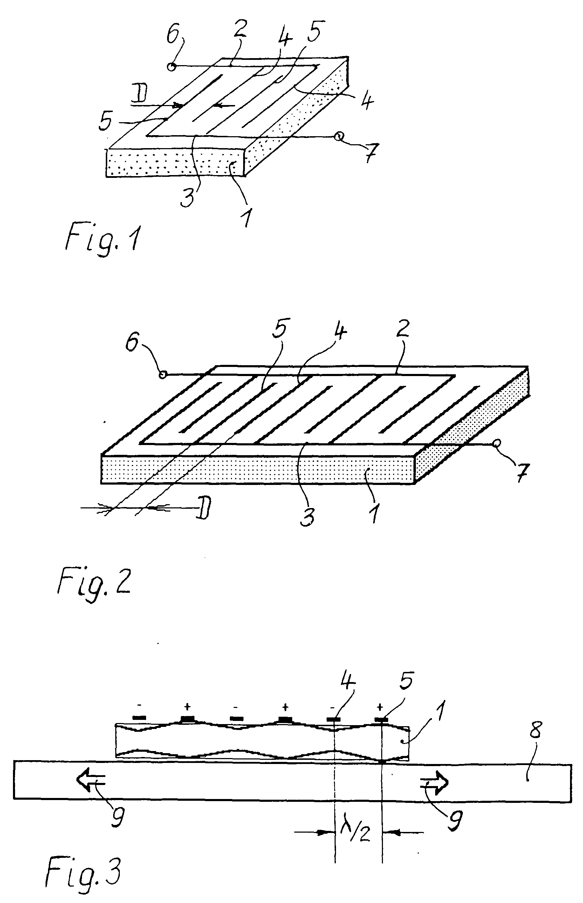

In Fig. 1 ist eine erste, einfache Form eines erfindungsgemäßen, auf der IDT-Struktur eines interdigitalen Wandlers (interdigital transducer) beruhenden Lambwellenerregers dargestellt. Auf einer Schicht 1 aus piezo-elektrischem Material sind zwei fingerartig ineinandergreifende Elektroden 2 und 3 aufgebracht, wobei die Finger 4 der einen Elektrode 2 zu den Fingern 5 der anderen Elektrode 3 einen gleichbleibenden Abstand D halten. Als piezo-elektrisches Material für die Schicht 1 wird bevorzugt ein Keramik- oder Compositematerial verwendet. Diese Stoffe haben u.a. den Vorteil einer geringen Temperaturabhängigkeit der Schallgeschwindigkeit.

Fig. 2 zeigt eine erweiterte Ausführungsform eines nach derselben IDT-Struktur aufgebauten Lambwellenerregers, der sich von dem nach Fig. 1 durch die Anzahl n der Finger 4 und 5 der beiden Elektroden 2 und 3 unterscheidet.

Wird an die Anschlüsse 6 und 7 der Elektroden 2 und 3 eine entsprechende hochfrequente Wechselspannung angelegt, so wird in der piezo-elektrischen Schicht 1 eine Dickenvibration ausgelöst, die sich als symmetrische Oberflächenwellen entlang beider Oberflächen der Schicht 1 ausbreitet, wie es in Fig. 3 angedeutet ist. Wie aus Fig. 3 ebenfalls zu erkennen ist, entspricht der Abstand D zwischen den Fingern 4 und 5 der Elektroden 2 und 3 der halben Wellenlänge λ/2 der aus der Dickenvibration der piezo-elektrischen Schicht 1 resultierenden, wellenartigen Oberflächenverformungen, so daß eine n*λ/2-fache Dickenvibration der Schicht 1 bewirkt wird, die im Bereich der Erregungsresonanz für die in einer Platte 8 oder Behälterwand 8 zu erregende s₀-mode -Lambwelle liegt, wobei n die Anzahl der Finger 4 und 5 der Elektroden 2 und 3 ist.

Um also in einer Platte 8 oder Behälterwand 8 eine *s*_{O}-mode-Lambwelle zu erregen, wird ein Lambwellenerreger gemäß Fig. 1 oder 2 parallel auf dieser Platte 8 oder Behälterwand 8 in guter akustischer Kopplung angebracht. Durch die über ihre Anschlüsse 6 und 7 an den Elektroden 2 und 3 angelegte Wechselspannung wird eine Dickenvibration in der piezo-elektrischen Schicht 1 hervorgerufen, welche sich durch die akustische Kopplung zwischen der piezo-elektrischen Schicht 1 und der Platte 8 oder Behälterwand 8 auf letztere überträgt und so aufgrund der oben beschriebenen Resonanzbedingungen zwischen der Ausbreitungsgeschwindigkeit der Longitudinalwellen in der piezo-elektrischen Schicht 1 und der Phasengeschwindigkeit der s_{O} -mode-Lambwelle in einer Platte 8 oder Behälterwand 8 in dieser Platte 8 oder Behälterwand 8 eine Lambwelle des *s*_{O}-modes erzeugt, die sich darin, wie durch die Pfeile 9 in Fig. 3 angedeutet, ausbreitet. Ein im Abstand zum Lambwellenerreger 10 an der Behälterwand 8 angeordneter Lambwellenempfänger 11, der, wie in Fig. 4 dargestellt, in gleicher Weise wie der Lambwellenerreger 10 als IDT-Wandler ausgebildet ist, kann diese *s*_{O}-mode-Lambwelle, solange sie sich ungedämpft ausbreiten kann, empfangen und in ein elektrisches Signal zurückverwandeln. Durch ein mit der Rückseite der Platte 8 oder der Innenfläche der Behälterwand 8 in Berührung kommendes Medium wird die *s*_{O} -mode-Lambwelle in ihrer Ausbreitung so gedämpft, daß das Ausbleiben des elektrischen Signals am Lambwellenempfänger 11 als Anzeige für einen bestimmten erreichten Füllstand im Bereich der Meßanordnung dienen kann.

Da bei dem beschriebenen Verfahren zur Erzeugung einer *s*_{O} -mode-Lambwelle, wie erwähnt, die Wellenlänge λ der Longitudinalewellen in der piezo-elektrischen Schicht 1 direkt bestimmt wird vom Abstand D zwischen den Fingern 4 und 5 der Elektroden 2 und 3 des IDT-Wandlers, ist es möglich, die Arbeitsfrequenz des IDT-Wandlers lediglich durch Veränderung dieses Abstandes D an die Phasenfrequenz der S_{O}-mode-Lambwelle in einem bestimmten Material anzupassen und so die jeweils beste Wirksamkeit bei der Erregung der Lambwelle zu erzielen, d.h. das Verfahren bzw. die Vorrichtung zur Durchführung des Verfahrens sind bei Behältern ganz unterschiedlichen Materials, wie beispielsweise Stahl, Messing, Aluminium oder auch Glas anwendbar, ohne daß an den Abmessungen der piezo-elektrischen Schicht 1 selbst irgendwelche Änderungen vorgenommen werden müssen. Die Anpassung des Abstandes D zwischen den Fingern der 4 und 5 der Elektroden 2 und 3 an das Behältermaterial kann numerisch nach der FEM-Simulation (finite element method) ermittelt werden. Die gemessene Wirksamkeit des IDT-Lambwellenerregers ist mit der herkömmlicher Lambwellenerreger, die ein piezo-elektrisches Element zusammen mit einem einen bestimmten Öffnungswinkel aufweisenden (Polymer-) Kunststoffprisma verwenden, vergleichbar. Da nach der Erfindung auf eine Prisma verzichtet werden kann, werden auch die mit ihm verbundenen, eingangs geschilderten Nachteile vermieden.

## Patentansprüche

1. Verfahren zur Erregung von Lambwellen in einer Platte, insbesondere in einer Behälterwand, nach dem ein an sich bekannter IDT-Wandler (interdigital transducer) bestehend aus einer Schicht (1) aus piezo-elektrischem Material, auf deren einen Oberfläche zwei fingerartig ineinander greifende Elektroden (2, 3) aufgebracht sind, mit der den Elektroden (2, 3) abgewandten Oberfläche akustisch mit der Platte (8) oder Behälterwand (8) gekoppelt wird und an die Anschlüsse (6, 7) der Elektroden (2, 3) eine hochfrequente Wechselspannung angelegt wird, die in der piezo-elektrischen Schicht (1) zwischen den Elektrodenfingern (4, 5) periodisch auftretende Materialverdichtungen und - verdünnungen, eine sogenannte Dickenvibration, auslöst, wobei die Ausbreitungs- oder Schallgeschwindigkeit der daraus resultierenden Longitudinalwellen in der piezo-elektrischen Schicht (1) abgestimmt wird auf die Phasengeschwindigkeit, mit der sich eine Lambwelle des *s*₀-modes im Material der Platte (8) oder Behälterwand (8) ausbreitet, indem der Abstand (D) zwischen den Fingern (4, 5) der Elektroden (2, 3) so gewählt wird, daß er gleich der halben Wellenlänge λ/2 der auszulösenden Longitudinalwelle in der piezo-elektrischen Schicht (1) ist.

2. Verfahren nach Anspruch 1, nach dem die Abstimmung der Ausbreitungs- oder Schallgeschwindigkeit der in der piezo-elektrischen Schicht (1) auzulösenden Longitudinalwellen an die Phasengeschwindigkeit der *s*₀-mode-Lambwelle im Material der Platte (8) oder Behälterwand (8) durch Veränderung des Abstandes (D) zwischen den Fingern (4, 5) der Elektroden (2, 3) des IDT-Wandlers durch FEM-Simulation (finite element method) vorgenommen wird.

3. Vorrichtung zur Erregung zum Empfang von Lambwellen in einer Platte(8), insbesondere einer Behälterwand (8), bei der ein an sich bekannter IDT-Wandler (interdigital transducer) bestehend aus einer piezo-elektrischen Schicht (1), auf deren einen Oberfläche zwei fingerartig ineinander greifende Elektroden (2, 3) aufgebracht sind, mit seiner den Elektroden (2, 3) abgewandten Oberfläche akustisch mit der Platte (8) oder Behälterwand (8) gekoppelt ist und die Anschlüsse (6, 7) der Elektroden (2, 3) mit einer hochfrequenten Wechselspannungsquelle verbunden sind, wobei der Abstand (D) zwischen den Fingern (4, 5) der beiden Elektroden (2, 3) gleich der halben Wellenlänge λ/2 der bei Anliegen der hochfrequenten Wechselspannung durch den piezo-elektrischen Effekt hervorgerufenen Dickenvibration in der piezo-elektrischen Schicht (1) ist und so die Ausbreitungs- oder Schallgeschwindigkeit der aus der Dickenvibration der piezo-elektrischen Schicht (1) resultierenden Longitudinalwellen auf die Phasengeschwindigkeit einer Lambwelle des *s*₀-modes im Material der Platte (8) oder Behälterwand (8) abgestimmt ist und bei der im Abstand zu diesem IDT-Wandler ein weiterer, gleichartiger IDT-Wandler in gleicher Weise auf der Platte (8) oder Behälterwand (8) für den Empfang der ausgelösten Lambwellen angeordnet ist.

4. Vorrichtung nach Anspruch 3, bei der jede der Elektroden (2, 3) mindesten zwei Elektrodenfinger (4, 5) aufweist, die unter Einhaltung des gegenseitigen Abstandes (D) fingerartig ineinandergreifen.

5. Vorrichtung nach Anspruch 3, bei der jede der Elektroden (2, 3) des IDT-Wandlers mehr als zwei Elektrodenfinger (4, 5) aufweist, die unter Einhaltung des gegenseitigen Abstandes (D) fingerartig ineinandergreifen.

6. Vorrichtung nach einem der Ansprüche 3 bis 5, bei der die piezo-elektrische Schicht (1) aus einem piezo-elektrischen Keramikstoff oder einem piezo-elektrischen Compositestoff besteht.
